# EUROPEAN PATENT APPLICATION

(11) **EP 2 402 986 A2**
(43) Date of publication of application: **04.01.2012**
(21) Application number: 11171400.2
(22) Date of filing: 24.06.2011
(51) Int. Cl.: H01L 21/677, H01L 21/67

(54) **Integrated Gearbox And Rotary Feedthrough System For A Vacuum Chamber Structure**

(30) Priority: 30.06.2010 US 826966
(71) Applicant: PrimeStar Solar, Inc, Arvada, CO 80004 (US)
(72) Inventor: Black, Russell Weldon, Arvada, CO Colorado 80004 (US)
(74) Representative: Bedford, Grant Richard

(57) **Abstract**

A vacuum chamber structure (102) includes a rotary feedthrough (100) configured on a chamber wall (104) to provide rotational drive to the interior of the structure. The rotary feedthrough includes a gearbox (108) having a housing (110) and a shaft (123) rotationally supported by bearings (112) contained within the housing. A motor (116) is operably coupled to the gearbox housing to drive the shaft, with the shaft extending from the gearbox. A seal assembly (126) is operably disposed between the gearbox housing and the chamber wall, with the shaft disposed through the seal assembly and extending through a bore (106) in the chamber wall and into the interior of the structure. The shaft is rotationally supported with bearings only via the bearings in the gearbox housing.

## Description

The present invention relates generally to a rotary feedthrough, and more particularly to a vacuum chamber structure in a vapor deposition system having an improved rotary feedthrough for providing rotary motion through a wall of the structure.

Production of thin film photovoltaic (PV) modules (also referred to as "solar panels") typically involves conveyance of a substrate, such as a glass panel, into and out of one or more vacuum chambers in a deposition system wherein a thin film layer (generally recognized in the industry as less than 10 µm) of a semiconductor material, such as cadmium telluride (CdTe), is deposited onto the surface of the substrate. The deposition process may be any known process, for example a close space sublimation (CSS) system, a chemical vapor deposition (CVD) system, or physical vapor deposition (PVD) system.

Deposition systems that entail conveyance of the substrates through the vacuum chamber structures typically use a driven conveyor or other suitable conveyance device. Thus, the need exists to establish controlled rotary motion inside of the vacuum chambers for driving the conveyor while maintaining the high vacuum condition within the structure. Conventional rotary feedthroughs provided for this purpose are relatively complicated and generally require a through shaft that is supported by bearings within or external to the chamber wall. The shaft is, in turn, operationally coupled to a gearbox and/or motor that provides the rotational drive via a direct coupling, belt drive, or chain drive. These conventional arrangements are relatively costly, complex, and bulky, and thus add to the overall cost of producing solar panels.

The success of solar panels becoming an accepted source of primary or secondary power on a large commercial or residential scale is dependent upon, among other things, the cost of producing the solar panels, which inevitably affects the final cost per kilowatt of solar energy to consumers. Any benefit in the manufacturing process of the solar panels that can reduce the cost of production is important. In this regard, the industry would benefit from a rotary feedthrough system particularly suited for use in vacuum chambers or modules that is compact, less complex, and less costly than conventional designs.

Various aspects and advantages of the invention will be set forth in part in the following description, or may be clear from the description, or may be learned through practice of the invention.

In one embodiment, a vacuum chamber structure is provided with a rotary feedthrough in accordance with aspects of the invention. The structure is not limited by its configuration or application of use and may be, for example, a module that is a component of a vacuum deposition system. The rotary feedthrough is configured on an exterior of the chamber wall to deliver rotary motion through a bore in the chamber wall to an interior of the structure for any intended purpose, such as for rotational drive of an internal conveyor system. In a particular embodiment, the rotary feedthrough includes a gearbox having a housing and an internal hollow shaft rotationally supported by bearings contained within the housing. A motor is operably coupled to the gearbox housing to drive the hollow shaft. An output shaft is disposed concentrically through and rotationally coupled to the hollow shaft. A seal assembly is operably disposed between the gearbox housing and the chamber wall, with the output shaft disposed through the seal assembly and extending through the bore in the chamber wall and into the interior of the structure. The output shaft is rotationally supported with bearings only indirectly via the bearings in the gearbox housing that rotationally support the hollow shaft.

The motor may be coupled to the hollow shaft in the gearbox housing by any suitable gearing, for example a worm gear configuration.

The output shaft may extend partially into or completely through the hollow shaft in the gearbox housing and is axially fixed relative to the hollow shaft by, for example, a keyed or other interlocking feature.

The seal assembly may comprise a seal housing and any type of seal surrounding the output shaft suitable for maintaining vacuum conditions within the structure.

In a particularly unique embodiment, the seal housing is the component that connects the rotary feedthrough to the chamber wall and may include a first flange connected to the gearbox housing and a second flange connected to the chamber wall around the bore, with a seal disposed between the second flange and the chamber wall. The second flange may be bolted to the chamber wall by bolts that extend through oversized bores in the second flange such that an axis of the second flange is adjustable relative to an axis of the bore in the chamber wall.

In another unique embodiment, a vacuum chamber structure includes a rotary feedthrough configured on an exterior of a wall to deliver rotary motion through a bore in the wall. The rotary feedthrough may include a gearbox having a housing and a shaft rotationally supported by bearings contained within the housing. The shaft may be a single component or multiple shaft segments axially aligned and coupled together. A motor is operably coupled to the gearbox housing to drive the shaft, with the shaft extending from the gearbox. A seal assembly is operably disposed between the gearbox housing and the chamber wall, with the shaft disposed through the seal assembly and extending through the bore in the chamber wall and into the interior of the structure. The shaft is rotationally supported by bearings only via the bearings in the gearbox housing.

Variations and modifications to the embodiment of the vapor deposition system discussed above are within the scope and spirit of the invention and may be further described herein.

Various features, aspects and advantages of the present invention will become better understood with reference to the following description, appended claims, and drawings in which:
Fig. 1 is a view of a vapor deposition system that may incorporate structures in the form of individual modules in accordance with aspects of the present invention;
Fig. 2 is a partial perspective view of a module incorporating a rotary feedthrough in accordance with aspects of the present invention;
Fig. 3 is a side cut-away and partial perspective view of an embodiment of a rotary feedthrough;
Fig. 4 is a side cut-away view of an embodiment of a rotary feedthrough; and,
Fig. 5 is a perspective view of a gearbox component of the rotary feedthrough of Figs. 2 and 3.

Reference now will be made in detail to embodiments of the invention, one or more examples of which are illustrated in the drawings. Each example is provided by way of explanation of the invention, not limitation of the invention. In fact, it will be apparent to those skilled in the art that various modifications and variations can be made in the present invention without departing from the scope or spirit of the invention. For instance, features illustrated or described as part of one embodiment, can be used with another embodiment to yield a still further embodiment. Thus, it is intended that the present invention encompass such modifications and variations as come within the scope of the appended claims and their equivalents.

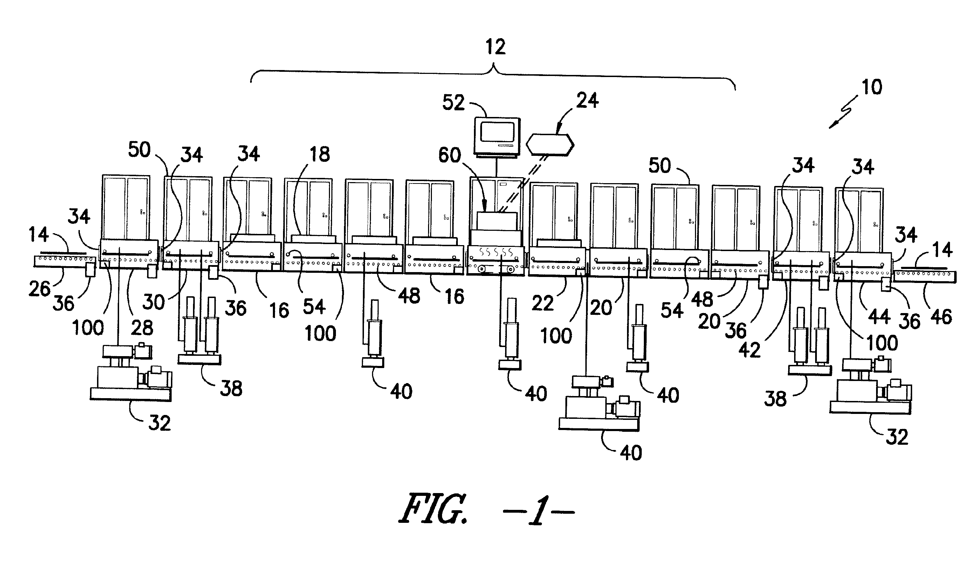

As mentioned, various aspects of the present invention relate to a novel rotary feedthrough that has particular usefulness in structures of a vapor deposition system for providing a rotary drive within a vacuum chamber. Fig. 1 illustrates an embodiment of a vapor deposition system 10 that may incorporate various embodiments of a rotary feedthrough 100 in accordance with aspects of the invention, particularly as components for driving conveyors within various types of modules that make up the system 10. For reference and an understanding of an environment in which the present rotary feedthroughs 100 may be used, the system 10 of Fig. 1 is described below, followed by a detailed description of particular embodiments of the rotary feedthroughs 100.

The system 10 is configured for deposition of a thin film layer on a photovoltaic (PV) module substrate 14 (referred to hereafter as "substrate"). The thin film may be, for example, a film layer of cadmium telluride (CdTe). As mentioned, it is generally recognized in the art that a "thin" film layer on a PV module substrate is generally less than about 10 microns (µm). It should be appreciated that the rotary feedthroughs 100 are not limited to use in the system 10 illustrated in Fig. 1, but may be incorporated into vacuum processing line.

Referring to Fig. 1, the exemplary system 10 includes a vacuum chamber 12 defined by a plurality of interconnected modules, one or more of which include a rotary feedthrough 100 for providing rotational drive to an internal conveyor 48. Any combination of vacuum pumps 40 may be configured with the interconnected modules to draw and maintain a vacuum effective for the deposition process within the chamber 12. A plurality of interconnected heater modules 16 define a pre-heat section of the vacuum chamber 12 through which the substrates 14 are conveyed and heated to a desired temperature before being conveyed into a vapor deposition apparatus 60. Each of the heater modules 16 may include a plurality of independently controlled heaters 18, with the heaters defining a plurality of different heat zones. A particular heat zone may include more than one heater 18. The heaters 18 may be disposed above or below the module bodies.

The vapor deposition apparatus 60 may take on various configurations and operating principles within the scope and spirit of the invention, and is generally configured for vapor deposition of a source material, such as CdTe, as a thin film on the PV module substrates 14. In the embodiment of the system 10 illustrated in Fig. 1, the apparatus 60 is a module that includes a casing in which the internal components are contained, including a vacuum deposition head mounted above a conveyor assembly.

The vacuum chamber 12 also includes a plurality of interconnected cool-down modules 20 within the vacuum chamber 12 downstream of the vapor deposition apparatus 60. The cool-down modules 20 define a cool-down section within the vacuum chamber 12 in which the substrates 14 having the thin film of source material deposited thereon are allowed to cool at a controlled cool-down rate prior to the substrates 14 being removed from the system 10. Each of the modules 20 may include a forced cooling system wherein a cooling medium, such as chilled water, refrigerant, or other medium is pumped through cooling coils configured with the modules 20.

In the illustrated embodiment of system 10, at least one post-heat module 22 is located immediately downstream of the vapor deposition apparatus 60 and before the cool-down modules 20. As the leading section of a substrate 14 is conveyed out of the vapor deposition apparatus 60, it moves into the post-heat module 22, which maintains the temperature of the substrate 14 at essentially the same temperature as the remaining portion of the substrate 14 within the vapor deposition apparatus 60. In this way, the leading section of the substrate 14 is not allowed to cool while the trailing section of the substrate 14 is still within the vapor deposition apparatus 60. If the leading section of a substrate 14 were allowed to cool as it exited the apparatus 60, a non-uniform temperature would be generated longitudinally along the substrate 14. This condition could result in the substrate breaking from thermal stress.

As diagrammatically illustrated in Fig. 1, a feed device 24 is configured with the vapor deposition apparatus 60 to supply source material, such as granular CdTe. Preferably, the feed device 24 is configured so as to supply the source material without interrupting the continuous vapor deposition process within the apparatus 60 or conveyance of the substrates 14 through the apparatus 60.

Still referring to Fig. 1, the individual substrates 14 are initially placed onto a load conveyor module 26, and are subsequently moved into an entry vacuum lock station that includes a load module 28 and a buffer module 30. A "rough" (i.e., initial) vacuum pump 32 is configured with the load module 28 to draw an initial vacuum, and a "fine" (i.e., high) vacuum pump 38 is configured with the buffer module 30 to increase the vacuum in the buffer module 30 to essentially the vacuum within the vacuum chamber 12. Valves 34 (e.g., gate type slit valves or rotary-type flapper valves) are operably disposed between the load conveyor 26 and the load module 28, between the load module 28 and the buffer module 30, and between the buffer module 30 and the vacuum chamber 12. These valves 34 are sequentially actuated by a motor or other type of actuating mechanism 36 in order to introduce the substrates 14 (starting at atmospheric pressure) into the vacuum chamber 12 in a step-wise manner without affecting the vacuum within the chamber 12.

An exit vacuum lock station is configured downstream of the last cool-down module 20, and operates essentially in reverse of the entry vacuum lock station described above. For example, the exit vacuum lock station may include an exit buffer module 42 and a downstream exit lock module 44. Sequentially operated valves 34 are disposed between the buffer module 42 and the last one of the cool-down modules 20, between the buffer module 42 and the exit lock module 44, and between the exit lock module 44 and an exit conveyor module 46. A fine vacuum pump 38 is configured with the exit buffer module 42, and a rough vacuum pump 32 is configured with the exit lock module 44. The pumps 32, 38 and valves 34 are sequentially operated to move the substrates 14 out of the vacuum chamber 12 in a step-wise fashion without loss of vacuum condition within the vacuum chamber 12.

System 10 also includes a coordinated conveyor system configured to move the substrates 14 into, through, and out of the vacuum chamber 12. In the illustrated embodiment, this conveyor system includes a plurality of individually controlled conveyor assemblies 48, with each of the various modules in the system 10 including one of the conveyor assemblies 48. The respective conveyor assemblies 48 include a rotary feedthrough 100.

As described, each of the various modules and respective conveyors in the system 10 are independently controlled to perform a particular function. For such control, each of the individual modules may have an associated independent controller 50 configured therewith to control the individual functions of the respective module, including the conveyance rate of the conveyor assemblies 48 (and thus the speed of the rotary feedthroughs 100). The plurality of controllers 50 may, in turn, be in communication with a central system controller 52, as illustrated in Fig. 1. The central system controller 52 can monitor and control (via the independent controllers 50) the functions of any one of the modules so as to achieve an overall desired heat-up rate, deposition rate, cool-down rate, and so forth, in processing of the substrates 14 through the system 10.

Referring to Fig. 1, for independent control of the functions performed by the modules within the overall system configuration 10, including individual control of the respective rotary feedthroughs 100, the modules include active-sensing viewport assemblies 54 that detect the presence of the substrates 14 as they are conveyed through the module. The viewport assemblies 54 are in communication with the respective module controller 50, which is in turn in communication with the central controller 52. The viewport assemblies 54 may be in direct communication with the central controller 52 in an alternate embodiment. In this manner, the individual respective conveyor assemblies 48/rotary feedthroughs 100 may be controlled to ensure that a proper spacing between the substrates 14 is maintained and that the substrates 14 are conveyed at the desired constant conveyance rate through the vacuum chamber 12. It should be appreciated that the viewport assemblies may be used for any other control function related to the individual modules or overall system 10.

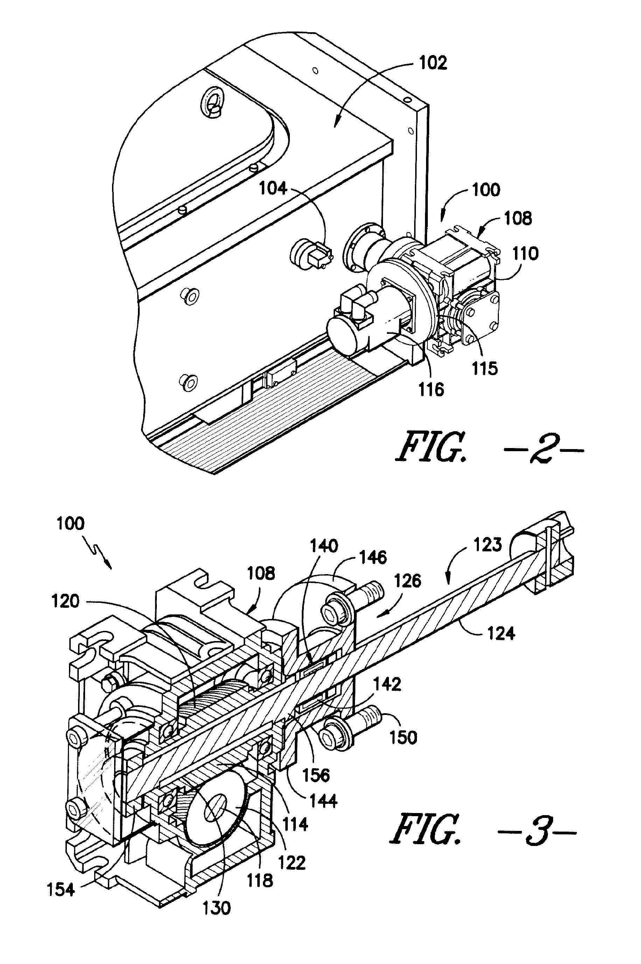

Fig. 2 illustrates an embodiment of a rotary feedthrough 100 in accordance with various aspects of the invention. The rotary feedthrough 100 is illustrated as configured on a side wall 104 of a vacuum chamber structure 102. The structure 102 may be one of the modules discussed above with respect to Fig. 1, or may be any other type of vacuum chamber structure wherein it is desired to provide a rotational drive to components within the structure 102. In the embodiment illustrated in Fig. 2, the rotary feedthrough 100 is configured on the exterior of the chamber wall via an attachment pipe or other structure 105 that is permanently affixed to the chamber wall 104. The pipe 105 defines a bore 106 through the chamber wall 104 to provide access to internal components within the structure 102. The pipe 105 may include a mounting flange 107 to which the rotary feedthrough 100 is mounted. It should be appreciated that the pipe 105 and flange 107 configuration merely provides a means for mounting the rotary feedthrough 100 relative to the chamber wall 104. In an alternative embodiment, the bore 106 may be defined directly through the chamber wall 104 with the rotary feedthrough 100 mounted directly onto the exterior surface of the wall 104.

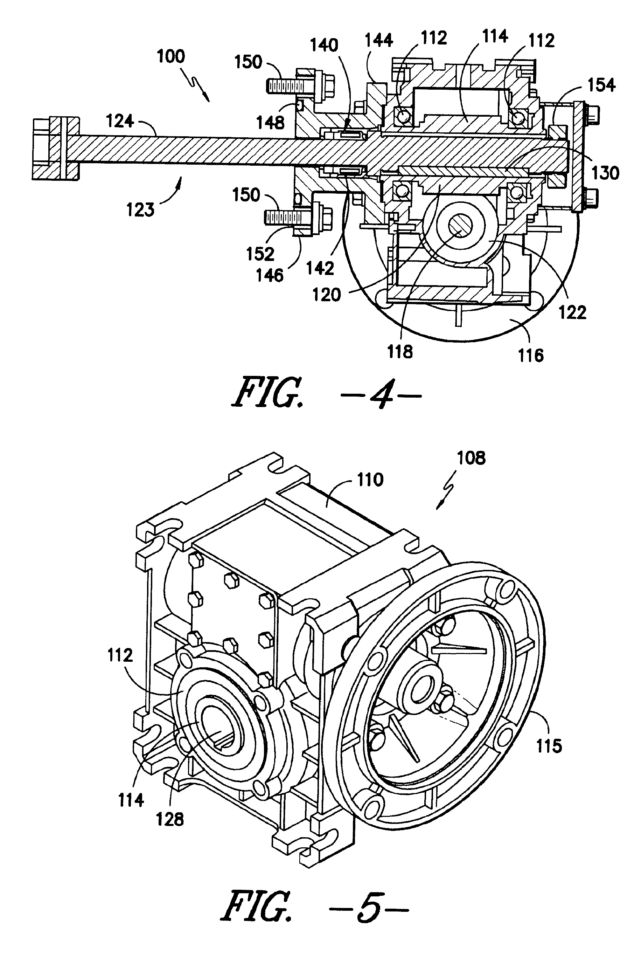

Referring to the remaining figures in general, the rotary feedthrough 100 includes a gearbox 108 having a housing 110. Internal components of the housing 110 are particularly illustrated in Figs. 3 and 4 and will be discussed in greater detail below. A motor 116 is operably coupled to the gearbox housing 110. The motor 116 may be electric, pneumatic, hydraulic, and the like. The motor 116 includes a motor drive shaft 118 that is geared to a shaft 123. As discussed in greater detail below, the shaft 123 may be a single integral component, or may include an assembly of different shaft components.

The shaft 123 extends from the gearbox housing 110 and into the vacuum chamber structure 102. For example, referring to Fig. 2, the shaft 123 would extend through the pipe 105 and into the interior volume of the structure 102.

Referring to Figs. 3 and 4, a seal assembly 126 is operably disposed between the gearbox housing 110 and the chamber wall 104. The shaft 123 is disposed through this seal assembly prior to extending through the bore 106 and into the interior of the structure 102. The seal assembly 126 is configured for maintaining vacuum conditions within the interior of the structure 102. In this regard, the seal assembly 106 includes any manner of suitable seal 142 that surrounds the shaft 123 within a seal assembly housing 140. The seal 142 may be, for example, an O-ring seal, face seal, lip seal, ferrofluidic seal, and the like. It should be appreciated that the invention is not limited to the particular type of seal 142 used within the seal housing 140.

Referring again to Figs. 3 and 4, bearings 112 are contained within the gearbox housing 110 and rotationally support the shaft 123. A unique feature of the present rotary feedthrough 100 is that the bearings 112 within the gearbox housing 110 are the only set of bearings needed for rotational support of the shaft 123. By engaging the motor drive shaft 118 directly with the shaft 123 within the gearbox housing 110 provides for a relatively simple and compact configuration of the rotary feedthrough 100. The gearing arrangement between the motor and shaft 123 is selected to provide the desired gear ratio range for most rotary applications of the rotary feedthrough 100. In the illustrated embodiment, a worm gear configuration is illustrated wherein a first worm gear component 122 is configured on the motor drive shaft 118 (Fig. 4) and the mating worm gear component 120 is configured on the shaft 123. This worm gear arrangement provides for a simple yet robust gear configuration that provides the desired torque and speed functions for the rotary feedthrough 100. It should be appreciated, however, that other suitable gearing arrangements may be utilized.

Although various gearboxes 108 are within the scope and spirit of the invention, applicant has found that a suitable gearbox for use with the invention as described herein is a model no. C21Q56H-10 from Morse. Referring to Figs. 2 and 5, this particular gearbox 108 includes a mounting flange 115 to which the motor 116 may be mounted, as illustrated in Fig. 2.

Referring to Figs. 3 and 4 in particular, in a particular embodiment of the seal housing 140, the housing includes a first flange 144 that connects to the gearbox housing 110 generally at the point where the shaft 123 extends from the housing. The seal assembly 126 includes an opposite flange 146 that mounts onto the exterior wall 104 of the structure 102, or structure associated with the exterior wall 104, such as the flange 107 extending from the pipe 105 as illustrated in Fig. 2. To provide at least some degree of axial adjustment of the axis of the shaft 123 relative to internal components within the structure 102, the flange 146 includes over-sized bores 152 through which mounting bolts 150 extend. The oversized bores 152 allow for adjustment of the flange 146 relative to the bore 106 to accommodate for axial alignment of the shaft 123 relative to the internal components of the structure 102. A seal 148 is configured with the face of the flange 146 to provide a sealing interface between the flange 146 and the mounting flange 107 or other mounting structure associated with the chamber wall 104.

In another embodiment illustrated in the figures and particularly seen in Figs. 3 and 4, the shaft 123 is assembled from multiple components. In particular, a hollow shaft 114 is disposed within the bearing housing 110 and is the component that is rotationally supported by the bearings 112. This hollow shaft component 114 also contains the worm gear component 120 that mates with the motor drive shaft 118. A second shaft component 124 is an elongated shaft member that extends at least partially into the hollow shaft 114 and is axially and rotationally fixed relative to the hollow shaft 114. For example, referring to Figs. 3 and 5, the shaft component 124 extends completely through the hollow shaft 114 and includes a spline 130 that engages within a recess 128 defined longitudinally along the inner diameter surface of the hollow shaft 114. Engagement of the spline 130 within the recess 128 rotationally locks the components together. The shaft 124 is axially fixed relative to the hollow shaft 114 via a stop or shoulder 156 at one end of the gearbox housing 110 and a clamping ring 154 at the opposite end of the gearbox housing which surrounds the shaft component 124. The shaft 124 may be a solid component or, in alternate embodiments, may also be a hollow shaft component.

With the embodiment particularly illustrated in Figs. 3 and 4, although the shaft 123 comprises multiple components, the completed shaft assembly 123 is still only supported by a set of bearings 112 within the gearbox housing 110. The output shaft 124 is indirectly supported by the bearings via its configuration with the hollow shaft 114. The output shaft 124 is not otherwise directly supported by bearings. The embodiment wherein an output shaft 124 extends through a hollow shaft 114 within a gearbox is also beneficial in that the output shaft 124 may be readily pulled and replaced with shafts of varying sizes. This adds greater flexibility and versatility to use of the rotary feedthrough 100. For example, the same gearbox 100 and motor 116 assembly may be configured for a particular manufacturing line, with variances between the particular uses of the feedthroughs 100 being accounted for by the different lengths of the output shafts 124. In this manner, a standardized repair/replacement gearbox 100 and/or motor 116 may be maintained in inventory.

This written description uses examples to disclose the invention, including the preferred mode, and also to enable any person skilled in the art to practice the invention, including making and using any devices or systems and performing any incorporated methods. The patentable scope of the invention is defined by the claims, and may include other examples that occur to those skilled in the art. Such other examples are intended to be within the scope of the claims if they include structural elements that do not differ from the literal language of the claims, or if they include equivalent structural elements with insubstantial differences from the literal languages of the claims.

Various aspects and embodiments of the present invention are defined by the following numbered clauses:
1. A vacuum chamber structure, comprising:
   a chamber wall;
   a rotary feedthrough configured on an exterior of said chamber wall to deliver rotary motion through a bore in said chamber wall to an interior of said structure, said rotary feedthrough comprising:
      a gearbox having a housing and an internal hollow shaft rotationally supported by bearings contained within said housing;
      a motor operably coupled to said gearbox housing to drive said hollow shaft;
      an output shaft disposed at least partially within and rotationally coupled to said hollow shaft; and,
      a seal assembly operably disposed between said gearbox housing and said wall, said output shaft disposed through said seal assembly and extending through said bore in said chamber wall and into said interior of said structure;
      wherein said output shaft is rotationally supported by bearings only indirectly via said bearings in said gearbox housing that rotationally support said hollow shaft.
2. The structure as in clause 1, wherein said motor comprises a drive shaft, and further comprising a worm gear arrangement between said drive shaft and said hollow shaft.
3. The structure as in any preceding clause, wherein said output shaft extends completely through said hollow shaft and is axially fixed relative to said hollow shaft.
4. The structure as in any preceding clause, wherein said seal assembly comprises a seal housing and a seal disposed within said seal housing surrounding said output shaft.
5. The structure as in any preceding clause, wherein said seal housing comprises a first flange connected to said gearbox housing and a second flange connected to said chamber wall around said bore, and further comprising a seal between said second flange and said chamber wall.
6. The structure as in any preceding clause, wherein said second flange is bolted to said chamber wall by bolts that extend through oversized bores in said second flange such that an axis of said second flange is adjustable relative to an axis of said bore in said wall.
7. The structure as in any preceding clause, wherein said structure is a vapor deposition module for use in conveying a substrate through a vapor deposition system wherein a source material is converted to a vapor and deposited onto a surface of a substrate.
8. The structure as in any preceding clause, further comprising a conveyor within said interior of said structure, said output shaft providing a rotary drive for said conveyor.
9. A vacuum chamber structure, comprising:
   a chamber wall;
   a rotary feedthrough configured on an exterior of said wall to deliver rotary motion through a bore in said chamber wall to an interior of said structure, said rotary feedthrough comprising:
      a gearbox having a housing and a shaft rotationally supported by bearings contained within said housing;
      a motor operably coupled to said gearbox housing to drive said shaft;
      said shaft extending from said gearbox; and,
      a seal assembly operably disposed between said gearbox housing and said chamber wall, said shaft disposed through said seal assembly and extending through said bore in said chamber wall and into said interior of said structure;
      wherein said shaft is rotationally supported by bearings only via said bearings in said gearbox housing.
10. The structure as in any preceding clause, wherein said motor comprises a drive shaft, and further comprising a worm gear arrangement between said drive shaft and said hollow shaft.
11. The structure as in any preceding clause, wherein said seal assembly comprises a seal housing and a seal disposed within said seal housing surrounding said shaft.
12. The structure as in any preceding clause, wherein said seal housing comprises a first flange connected to said gearbox housing and a second flange connected to said chamber wall around said bore, and further comprising a seal between said second flange and said wall.
13. The structure as in any preceding clause, wherein said second flange is bolted to said chamber wall by bolts that extend through oversized bores in said second flange such that an axis of said second flange is adjustable relative to an axis of said bore in said chamber wall.
14. The structure as in any preceding clause, wherein said structure is a vapor deposition module for use in conveying a substrate through a vapor deposition system wherein a source material is converted to a vapor and deposited onto a surface of a substrate.
15. The structure as in any preceding clause, further comprising a conveyor within said interior of said module, said shaft providing a rotary drive for said conveyor.
16. The structure as in any preceding clause, wherein said shaft comprises a first shaft segment within said gearbox housing that is rotationally supported by said bearings in said gearbox housing, and a second shaft component that is connected to said first shaft component and that extends through said seal housing and into said interior of said module.
17. The structure as in any preceding clause, wherein said first shaft component is hollow and said second shaft component extends concentrically into said first shaft component.
18. The structure as in any preceding clause, wherein said bearings within said gearbox housing are the only bearings that rotationally support said first and second shaft components.
19. The structure as in any preceding clause, wherein said second shaft component extends completely through said first shaft component and is rotationally fixed to said first shaft component.

## Claims

1. A vacuum chamber structure (12), comprising:
a chamber wall (104);
a rotary feedthrough (100) configured on an exterior of said chamber wall to deliver rotary motion through a bore (106) in said chamber wall to said interior of said structure, said rotary feedthrough comprising:
a gearbox (108) having a housing (110) and an internal hollow shaft (114) rotationally supported by bearings (112) contained within said housing;
a motor (116)operably coupled to said gearbox housing to drive said hollow shaft;
an output shaft (124) disposed at least partially within and rotationally coupled to said hollow shaft; and
a seal assembly (126) operably disposed between said gearbox housing and said wall,
said output shaft disposed through said seal assembly and extending through said bore in said chamber wall and into said interior of said structure;
wherein said output shaft is rotationally supported by bearings only indirectly via said bearings in said gearbox housing that rotationally support said hollow shaft.

2. The structure (12) as in claim 1, wherein said motor (116) comprises a drive shaft (118), and further comprising a worm gear arrangement (120, 122) between said drive shaft and said hollow shaft.

3. The structure (12) as in any preceding claim, wherein said output shaft (124) extends completely through said hollow shaft (114) and is axially fixed relative to said hollow shaft.

4. The structure (12) as in any preceding claim, wherein said seal assembly (126) comprises a seal housing (140) and a seal (142) disposed within said seal housing surrounding said output shaft, said seal housing further comprising a first flange (144) connected to said gearbox housing (110) and a second flange (146) connected to said chamber wall (104) around said bore (106), and further comprising a seal (148) between said second flange and said chamber wall.

5. The structure (12) as in claim 4, wherein said second flange (146) is bolted to said chamber wall by bolts (150) that extend through oversized bores (152) in said second flange such that an axis of said second flange is adjustable relative to an axis of said bore (106) in said wall.

6. The structure (12) as in any preceding claim, wherein said structure is a vapor deposition module for use in conveying a substrate (14) through a vapor deposition system (10) wherein a source material is converted to a vapor and deposited onto a surface of a substrate, said module further comprising an internal conveyor (48), said output shaft (124) providing a rotary drive for said conveyor.

7. A vacuum chamber structure (12), comprising:
a chamber wall (104);
a rotary feedthrough (100) configured on an exterior of said chamber wall to deliver rotary motion through a bore (106) in said chamber wall to an interior of said structure, said rotary feedthrough comprising:
a gearbox (108) having a housing (110) and a shaft (123) rotationally supported by bearings (112) contained within said housing;
a motor (116) operably coupled to said gearbox housing to drive said shaft;
said shaft extending from said gearbox; and
a seal assembly (126) operably disposed between said gearbox housing and said chamber wall, said shaft disposed through said seal assembly and extending through said bore in said chamber wall and into said interior of said structure;
wherein said shaft is rotationally supported by bearings only via said bearings (112) in said gearbox housing.

8. The structure (12) as in claim 7, wherein said motor (116) comprises a drive shaft (118), and further comprising a worm gear arrangement (120, 122) between said drive shaft and said shaft (123).

9. The structure (12) as in claim 7 or claim 8, wherein said seal assembly (126) comprises a seal housing (140) having a first flange (144) connected to said gearbox housing (110) and a second flange (146) connected to said chamber wall (104) around said bore (106), and further comprising a seal (142) disposed within said seal housing surrounding said shaft (123).

10. The structure (12) as in any of claims 7 to 9, wherein said structure is a vapor deposition module for use in conveying a substrate (14) through a vapor deposition system (10) wherein a source material is converted to a vapor and deposited onto a surface of a substrate, said module further comprising an internal conveyor (48), said shaft (123) providing a rotary drive for said conveyor.

11. The structure (12) as in any of claims 7 to 10, wherein said shaft comprises a first shaft segment (114) within said gearbox housing (110) that is rotationally supported by said bearings (112) in said gearbox housing, and a second shaft component (124) that is connected to said first shaft component and that extends through said seal housing (140) and into said interior of said module.

12. The structure (12) as in any of claims 7 to 11, wherein said first shaft component (114) is hollow and said second shaft component (124) extends concentrically into said first shaft component.

13. The structure (12) as in any of claims 7 to 12, wherein said bearings (112) within said gearbox housing (110) are the only bearings that rotationally support said first (114) and second (124) shaft components.

14. The structure (12) as in any of claims 7 to 13, wherein said second shaft component (124) extends completely through said first shaft component (114) and is rotationally fixed to said first shaft component.
